# DEMANDE DE BREVET EUROPEEN

(11) **EP 1 681 725 A1**
(43) Date de publication de la demande: **19.07.2006**
(21) Numéro de dépôt: 06100471.9
(22) Date de dépôt: 17.01.2006
(51) Int. Cl.: H01L 29/872

(54) **Composant unipolaire vertical à faible courant de fuite**

(30) Priorité: 18.01.2005 FR 0550141
(71) Demandeur: ST MICROELECTRONICS S.A., 92120 Montrouge (FR)
(72) Inventeur: Lanois, Frédéric, 37100, Tours (FR)
(74) Mandataire: de Beaumont, Michel

(57) **Abrégé**

L'invention concerne une diode Schottky de type TMBS comprenant des électrodes principales (7) sur des zones actives du côté de la face supérieure et une électrode principale (8) du côté de la face inférieure, comprenant du côté de la face supérieure des doigts conducteurs (13) pénétrant entre les zones actives et polarisés, directement ou indirectement, comme les zones actives. Les doigts (13) comprennent des portions plus rapprochées du côté de leur partie supérieure que du côté de leur fond. Les doigts sont de préférence des doigts de silicium polycristallin isolés par une couche isolante telle que de l'oxyde de silicium.

## Description

### Domaine de l'invention

La présente invention concerne les composants unipolaires verticaux.

### Exposé de l'art antérieur

La description suivante vise plus particulièrement, uniquement à titre d'exemple, le cas de composants de type diode Schottky réalisés sous forme verticale dans des substrats de silicium. Toutefois l'invention s'applique également à toute structure unipolaire verticale et à sa formation monolithique dans un substrat semiconducteur.

De façon classique une diode Schottky comporte un substrat semiconducteur fortement dopé, typiquement en silicium monocristallin. Une couche de cathode plus faiblement dopée que le substrat recouvre le substrat. Une couche métallique ou plus couramment un siliciure métallique forme un contact Schottky avec la cathode et constitue l'anode de la diode.

La réalisation de tels composants unipolaires se heurte à deux contraintes opposées. Ils doivent présenter une résistance à l'état passant (Ron) la plus petite possible tout en ayant une tension de claquage élevée. Minimiser la résistance à l'état passant impose de minimiser l'épaisseur de la couche la moins dopée et de maximiser le dopage de cette couche. Au contraire, pour obtenir une tension de claquage en inverse élevée, il faut minimiser le dopage de la couche la moins dopée et maximiser son épaisseur, tout en évitant de créer des zones dans lesquelles les équipotentielles sont fortement courbées.

On a proposé diverses solutions pour concilier ces contraintes opposées et on est arrivé à des structures de diodes Schottky à capacité MOS, couramment désignées par l'appellation TMBS, de l'expression anglaise Trench MOS Barrier Schottky. Dans un exemple de telles structures, des doigts conducteurs, par exemple en silicium polycristallin fortement dopé de type N, sont formés dans une partie supérieure d'une couche épaisse de cathode moins fortement dopée de type N qu'un substrat sous-jacent. Une couche isolante isole les doigts conducteurs de la couche épaisse. Une couche d'anode recouvre l'ensemble de la structure, contactant la surface supérieure des doigts conducteurs isolés et formant un contact Schottky avec la cathode.

En polarisation inverse, les doigts conducteurs isolés provoquent une déplétion latérale de la partie de la couche de cathode, ce qui modifie la répartition des équipotentielles dans cette couche. Cela permet d'accroître le dopage de la couche de cathode, donc de réduire la résistance à l'état passant sans effet adverse sur la tension de claquage en inverse.

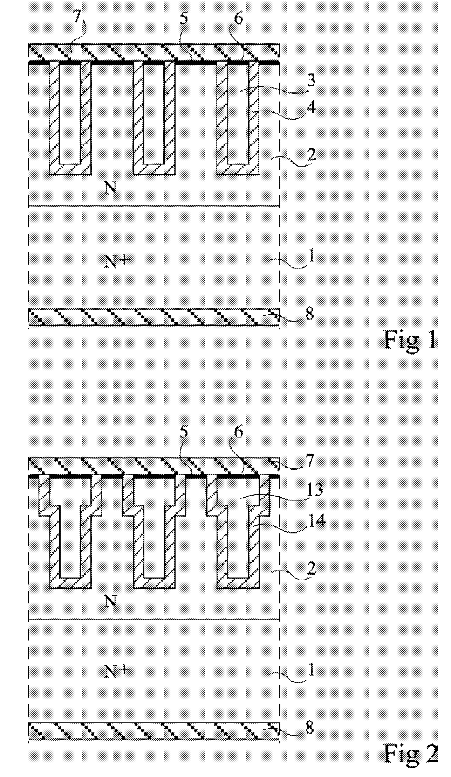

La figure 1 est une vue partielle d'un exemple de diode Schottky TMBS selon l'art antérieur. La diode est formée à partir d'une plaquette de silicium 1 fortement dopée de type N sur laquelle est formée une couche épitaxiale 2 faiblement dopée de type N. Dans cette couche épitaxiale, dans la zone correspondant au composant lui-même, sont formées des ouvertures, par exemple en forme de tranchées. Dans ces ouvertures sont formés des doigts conducteurs 3, par exemple en silicium polycristallin dopé pour être conducteur, une couche isolante 4 étant interposée entre chaque doigt conducteur et les parois de l'ouverture correspondante. La couche isolante 4 résulte par exemple d'une oxydation thermique et le remplissage de silicium polycristallin peut se faire par dépôt conforme, ces étapes de remplissage étant suivies d'une étape de planarisation. Après quoi, on dépose un métal, par exemple du nickel susceptible de former un siliciure 5 au-dessus des régions de silicium monocristallin et 6 au-dessus des zones de remplissage de silicium polycristallin. Une fois le siliciure formé, le métal n'ayant pas réagi avec le silicium est éliminé par gravure sélective. Après quoi, un dépôt métallique d'anode 7 est formé du côté de la face supérieure et un dépôt métallique de cathode 8 est formé du côté de la face inférieure.

Par rapport à une diode Schottky sans tranchées, la structure TMBS de la figure 1 améliore bien, comme cela est recherché, la chute de tension en direct pour une tenue en tension en inverse recherchée.

Toutefois, dans cette structure, la réduction du courant de fuite en inverse pose problème. En effet, le concepteur peut choisir un certain nombre de paramètres mais certains d'entre eux sont fixés par les premiers choix effectués. Généralement, le premier paramètre qui est fixé est la tension de claquage en inverse. Si l'on recherche par exemple une tension de claquage en inverse de 120 volts à 25°C, on pourra choisir diverses valeurs pour le niveau de dopage de la couche 2 de type N, étant entendu qu'un niveau de dopage plus élevé favorisera une plus faible chute de tension en direct. Par exemple, le tableau 1 ci-dessous donne des exemples de structures A et B ayant toutes deux une tension de claquage en inverse de 120 V et présentant l'une un niveau de dopage de l'ordre de 5.10¹⁵ atomes/cm³ et l'autre de 1,3.10¹⁶ atomes/cm³ pour la couche épitaxiée 2.

**Tableau 1**

| Structure | VBR(V) | N(at/cm3) | W(µm) | VF(v) | IR(mA) |
|---|---|---|---|---|---|
| A | 120 | 5.10¹⁵ | 7 | 0,58 | 6,2 |
| B | 120 | 1,3.10¹⁶ | 5,5 | 0,46 | 51 |

Dans le tableau 1, VBR désigne la tension de claquage exprimée en volts, N le niveau de dépôt de dopage de la couche épitaxiée en atome par cm³, W l'épaisseur de la couche épitaxiée en micromètres, VF la chute de tension en direct à 125°C en volts, et IR le courant de fuite en inverse à 125°C en milliampères. On voit qu'une augmentation du niveau de dopage et une diminution de l'épaisseur de la couche épitaxiée amènent à une nette réduction de la chute de tension en direct qui passe de 0,58 à 0,46 volt. Par contre, le courant de fuite en inverse augmente nettement, et passe de 6,2 mA à 51 mA. Ceci est lié au fait que, quand le niveau de dopage de la couche épitaxiée augmente, le champ au niveau de la barrière Schottky (ou jonction Schottky) augmente, ce qui entraîne inévitablement une augmentation du courant de fuite.

La présente invention vise à prévoir un nouveau composant de type TMBS présentant à la fois une faible chute de tension en direct et un courant de fuite en inverse faible.

### Résumé de l'invention

Pour atteindre cet objet, la présente invention prévoit un composant unipolaire vertical comprenant des électrodes principales sur des zones actives du côté de la face supérieure et une électrode principale du côté de la face inférieure, comprenant du côté de la face supérieure des doigts conducteurs pénétrant entre les zones actives et polarisés, directement ou indirectement, comme les zones actives. Les doigts comprennent des portions plus rapprochées du côté de leur partie supérieure que du côté de leur fond.

Selon un mode de réalisation de la présente invention, le composant unipolaire vertical constitue une diode Schottky de type TMBS et les doigts sont des doigts de silicium polycristallin isolés par une couche isolante telle que de l'oxyde de silicium, les doigts comportant une partie supérieure plus large que leur partie inférieure.

Selon un mode de réalisation de la présente invention, des doigts parallèles et profonds sont encadrés par des doigts parallèles moins profonds et plus rapprochés.

Selon un mode de réalisation de la présente invention, des doigts parallèles et profonds sont croisés par des doigts parallèles moins profonds et plus rapprochés.

La présente invention vise aussi un procédé de fabrication d'une diode Schottky TMBS, comprenant les étapes consistant à former dans la couche supérieure du composant des doigts de silicium polycristallin entourés d'oxyde de silicium ; graver partiellement la couche d'oxyde de silicium entourant la partie supérieure des doigts ; procéder à une oxydation thermique ; et procéder à un remplissage par du silicium polycristallin des parties creuses restantes.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe partielle de la partie active d'un composant TMBS selon l'art antérieur ;
la figure 2 est une vue en coupe schématique et partielle de la partie active d'un composant TMBS selon un mode de réalisation de la présente invention ;
les figures 3A et 3B sont respectivement une vue en coupe et une vue de dessus de la partie active d'un composant TMBS selon un mode de réalisation de la présente invention ;
les figures 4A, 4B et 4C sont respectivement deux vues en coupe et une vue de dessus de la partie active d'un composant TMBS selon un mode de réalisation de la présente invention ;
les figures 5A, 5B, 5C sont des vues en coupe d'étapes successives d'un procédé particulier de réalisation d'un composant TMBS selon un mode de réalisation de la présente invention ; et
la figure 5D est une vue de dessus correspondant à la vue en coupe de la figure 5C.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

La figure 2 illustre un mode de réalisation de la présente invention. On retrouve le substrat 1, la couche épitaxiée 2, les contacts Schottky 5 sur la surface supérieure de la couche épitaxiée 2, la métallisation correspondante 6 sur des zones de silicium polycristallin, l'électrode supérieure 7 et l'électrode inférieure 8 déjà décrits en relation avec la figure 1. Les doigts conducteurs, par exemple en silicium polycristallin sont désignés par la référence 13 et leur isolement par la référence 14. Selon l'invention, comme cela est représenté en figure 1, les doigts conducteurs 13 sont plus rapprochés dans leurs parties supérieures que dans leurs parties inférieures. Ainsi, quand une tension inverse est appliquée, le pincement survient pour une tension plus faible dans la partie supérieure de la couche épitaxiée 2 située entre les doigts que dans la partie inférieure de cette couche épitaxiée située entre les doigts. Il en résulte, quand la diode est polarisée en inverse, une plus forte déplétion de la partie de la couche épitaxiée 2 située entre les doigts conducteurs au niveau de la face supérieure, et donc une réduction du champ au niveau de la face supérieure et une réduction du courant de fuite en inverse.

Le mode de réalisation de la présente invention illustré en figure 2, dans lequel le conducteur assurant le pincement des zones de la couche épitaxiée comprises entre elles est plus large en haut qu'en bas, est susceptible de nombreuses variantes de réalisation. Par exemple, les tranchées pourraient être en forme de V, la pointe du V étant dirigée vers le bas.

On va décrire en relation avec les figures suivantes d'autres modes de réalisation de l'invention, uniquement à titre d'exemple.

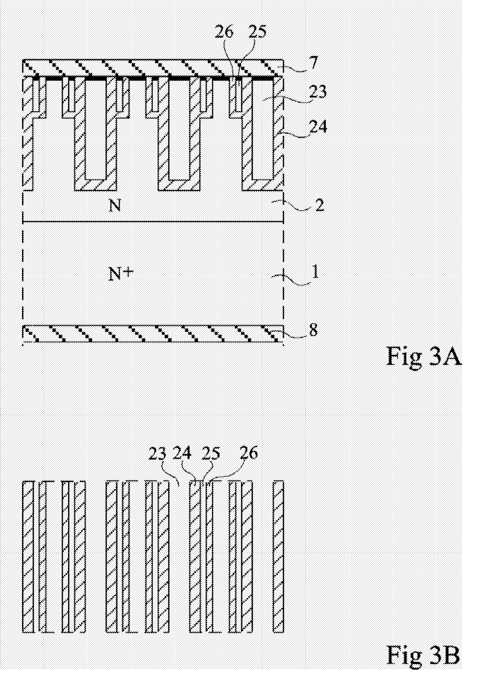

Un mode de réalisation de la présente invention est représenté en vue en coupe en figure 3A et en vue de dessus en figure 3B. Les doigts conducteurs sont formés dans des tranchées comprenant des tranchées principales encadrées de tranchées latérales moins profondes. Les tranchées principales contiennent des doigts conducteurs 23 isolés par un oxyde 24. Les tranchées latérales contiennent des doigts conducteurs 25 isolés par un oxyde 26. L'oxyde 26 peut avoir une épaisseur plus faible que l'oxyde 24, ce qui permet une déplétion de la région située sous le siliciure et une réduction plus importante du champ sous le siliciure. Les doigts 23 et 25 sont en contact avec la couche d'anode, éventuellement par l'intermédiaire du métal Schottky qui s'y est déposé lors du processus de fabrication. Comme l'illustre la vue de dessus de la figure 3B, les tranchées sont en forme de bandes parallèles.

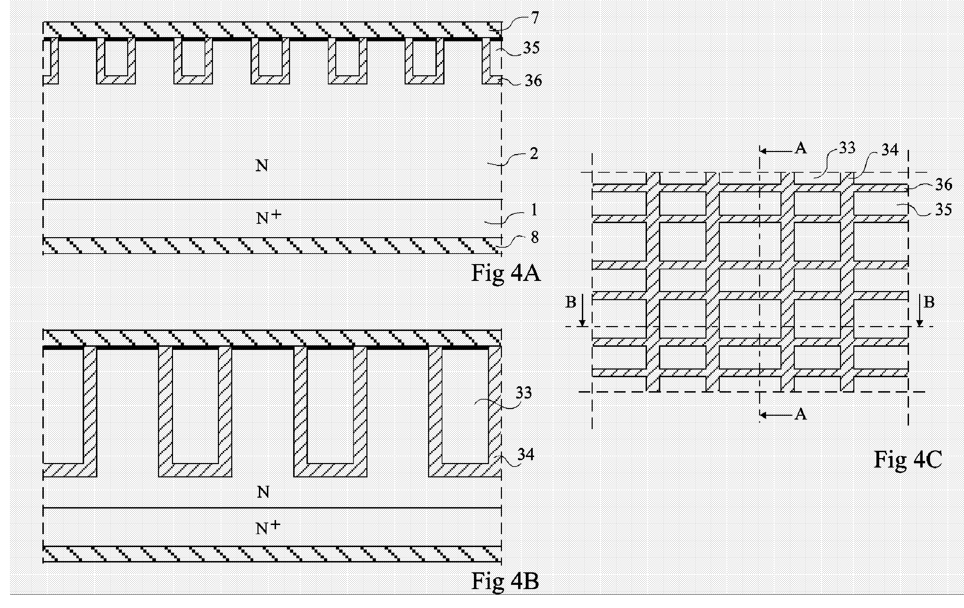

Les figures 4A à 4C illustrent un autre mode de réalisation de la présente invention, les figures 4A à 4B étant des vues en coupe, respectivement prises selon les plans A-A et B-B de la figure 4C. Dans ce mode de réalisation, on prévoit une première série de tranchées plus profondes et plus distantes contenant des doigts conducteurs 33 entourée d'un isolant 34 et une deuxième série de tranchées moins profondes et plus rapprochées 35 contenant des doigts conducteurs 35 entourés d'un isolant 36. Ces deux jeux de tranchées sont par exemple orthogonaux comme cela est représenté dans la vue de dessus de la figure 4C. On comprendra que les tranchées plus rapprochées assurent une déplétion plus importante dans la zone de surface du composant. L'isolant 36 peut avoir une épaisseur plus faible que l'isolant 34, ce qui permet une déplétion de la région située sous le siliciure et une réduction plus importante du champ sous le siliciure.

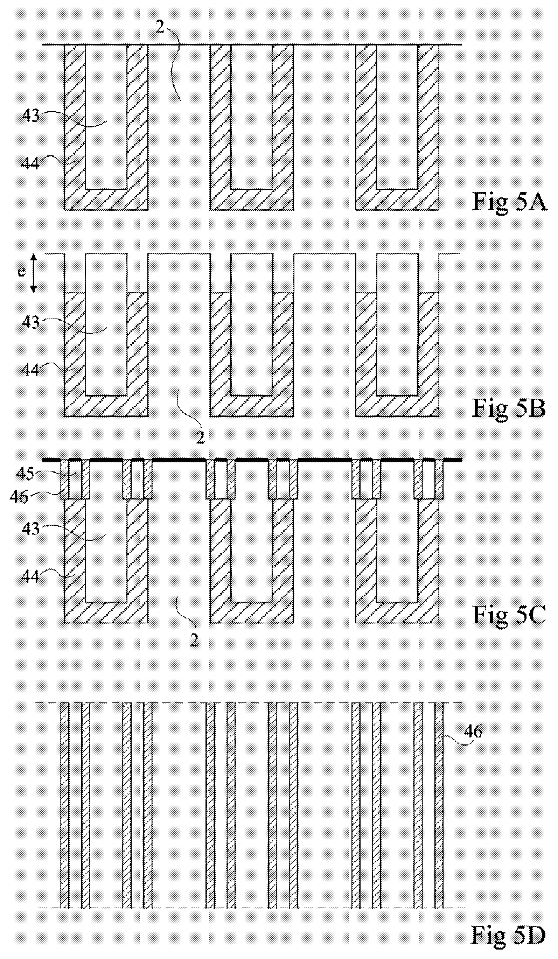

Les figures 5A à 5C sont des vues en coupe illustrant un exemple de procédé de fabrication d'un autre mode de réalisation de la présente invention.

Comme l'illustre la figure 5A, on commence par former des tranchées profondes contenant des doigts conducteurs 43 entourés d'un isolant 44. Pour ce faire, on commence par réaliser des tranchées de la forme souhaitée (forme de bande ou ouvertures rondes ou carrées) puis on procède à une oxydation thermique pour former l'isolant 44 et ensuite la tranchée est remplie d'un conducteur, par exemple du silicium polycristallin fortement dopé.

Dans une étape ultérieure, illustrée en figure 5B, on procède à une gravure sélective de l'oxyde de silicium 44 sur une profondeur limitée e.

Après cela, comme l'illustre la figure 5C, on procède à nouveau à une oxydation thermique pour former des zones isolantes 46 au-dessus de la partie supérieure latérale évidée des tranchées sur la profondeur e et l'on remplit les tranchées partielles ainsi formées d'un conducteur 45, à nouveau de préférence du silicium polycristallin dopé.

Après cela, on procède aux étapes habituelles de formation d'un composant de type TMBS.

Le tableau 2 compare les caractéristiques d'une structure TMBS selon l'art antérieur (C) à celles d'une structure du type de celle présentée en figure 5 (D), avec les mêmes notations que celles adoptées pour le tableau 1. On notera la réduction importante du courant de fuite en inverse

**Tableau 2**

| Structure | VBR (V) | N(at/cm3) | W(µm) | VF(v) | IR(mA) |
|---|---|---|---|---|---|
| C | 120 | 1,2.10¹⁶ | 6 | 0,47 | 33 |
| D | 120 | 1,2.10¹⁶ | 6 | 0,47 | 10 |

La présente invention est susceptible de nombreuses variantes adaptées aux divers types de composants à barrière Schottky. Par exemple, dans certaines réalisations, le composant à barrière Schottky, au lieu de comprendre des tranchées isolées latéralement, pourra comprendre des régions de type P convenablement dopées par rapport à la couche épitaxiée. Ces régions de type P auront selon la présente invention, une partie supérieure plus large que leur partie inférieure. De même, on connaît des réalisations dans lesquelles on forme des régions de type P ou des régions conductrices isolées espacées les unes des autres en profondeur. Dans ces deux derniers cas, les régions de type P ou les régions conductrices isolées pourront être polarisées indirectement par effet capacitif. A nouveau, selon l'invention les régions supérieures comprendront des portions plus rapprochées que les régions inférieures.

## Revendications

1. Composant unipolaire vertical comprenant des électrodes principales (7) sur des zones actives du côté de la face supérieure et une électrode principale (8) du côté de la face inférieure, comprenant du côté de la face supérieure des doigts conducteurs (13 ; 23, 25 ; 33, 35) pénétrant entre les zones actives et polarisés, directement ou indirectement, comme les zones actives, **caractérisé en ce que** lesdits doigts (13 ; 23, 25 ; 33, 35) comprennent des portions plus rapprochées du côté de leur partie supérieure que du côté de leur fond.

2. Composant unipolaire vertical selon la revendication 1, constituant une diode Schottky de type TMBS dans laquelle les doigts sont des doigts de silicium polycristallin isolés par une couche isolante telle que de l'oxyde de silicium, les doigts (13) comportant une partie supérieure plus large que leur partie inférieure.

3. Composant unipolaire vertical selon la revendication 2, dans lequel des doigts parallèles et profonds (23) sont encadrés par des doigts parallèles moins profonds et plus rapprochés (25).

4. Composant unipolaire vertical selon la revendication 2, dans lequel des doigts parallèles et profonds (33) sont croisés par des doigts parallèles moins profonds et plus rapprochés (35).

5. Procédé de fabrication d'une diode Schottky TMBS, **caractérisé en ce qu'**il comprend les étapes suivantes :
former dans la couche supérieure du composant des doigts de silicium polycristallin (43) entourés d'oxyde de silicium (44) ;
graver partiellement la couche d'oxyde de silicium entourant la partie supérieure des doigts ;
procéder à une oxydation thermique ; et
procéder à un remplissage par du silicium polycristallin (45) des parties creuses restantes.
